(19) Europäisches Patentamt
European Patent Office
Office européen des brevets

(11) **EP 4 425 189 A1**

(12) # EUROPEAN PATENT APPLICATION

(43) Date of publication:
**04.09.2024 Bulletin 2024/36**

(21) Application number: **23159362.5**

(22) Date of filing: **01.03.2023**

(51) International Patent Classification (IPC):
**G01P 15/125** (2006.01)   **B81B 3/00** (2006.01)

(52) Cooperative Patent Classification (CPC):
**B81B 3/0021; G01P 15/0802; G01P 15/125;**
B81B 2201/0235; B81B 2201/033; B81B 2203/051;
B81C 2203/036

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Murata Manufacturing Co., Ltd.
Nagaokakyo-shi, Kyoto 617-8555 (JP)**

(72) Inventor: **Liukku, Matti
Helsinki (FI)**

(74) Representative: **Boco IP Oy Ab
Kansakoulukatu 3
00100 Helsinki (FI)**

(54) **CAPACITIVE MEMS DEVICE**

(57)      A MEMS structure including a mechanical layer, which extends parallel to a reference device plane. The mechanical layer is patterned to include a static electrode and a movable electrode enabled to move in relation to the static electrode parallel to the reference device plane. The static electrode and the movable electrode are connected to form a capacitor wherein capacitance of the capacitor varies according to an overlap of the static electrode and the movable electrode. The mechanical layer includes a first silicon layer and a second silicon layer. Parts of the first silicon layer and the second silicon layer are directly bonded to each other. The movable electrode is in the first silicon layer and the static electrode is in the second silicon layer. The movable electrode is separated from the static electrode by a first gap in the interface between the first silicon layer and the second silicon layer.

Figure 2

Processed by Luminess, 75001 PARIS (FR)

**Description**

FIELD OF THE DISCLOSURE

The present disclosure relates to microelectromechanical devices, and more particularly to microelectromechanical devices detecting or actuating motions capacitively in an in-plane direction.

BACKGROUND

The term microelectromechanical system (MEMS) refers here to a miniaturised element that is manufactured using semiconductor microfabrication technologies. Mechanical dimensions in MEMS elements typically range from values below one micron to some millimeters. A MEMS includes mechanical or electromechanical elements, configured to implement a mechanical functionality in response to a detected phenomenon. A signal that corresponds with the detection may be generated by means of structural parts that are movable or structural parts that dynamically damp movement of parts that are movable in response to a detected phenomenon.

Capacitance is widely used in MEMS to convert induced movements to electrical signals or to convert input voltage to induced motion. To implement capacitive conversion, a conductive part that is movable and a static conductive part can be electrically isolated by an intermediate nonconductive part. When the movable and static parts are connected into different potentials, they form a capacitive transducer, a capacitor. The static and movable conductive parts are typically arranged to have opposing planar surfaces and changes in capacitance relate to a change in overlapping area of the opposing surfaces, or a change in the distance between the opposing surfaces.

These two transduction modes can be modelled with a parallel plate capacitor, wherein two conductive plates are isolated by a dielectric and coupled to a voltage source V. The capacitance C of the parallel plate capacitor is:

$$C = \frac{\varepsilon A}{d} = \frac{\varepsilon w l}{d} \qquad (1)$$

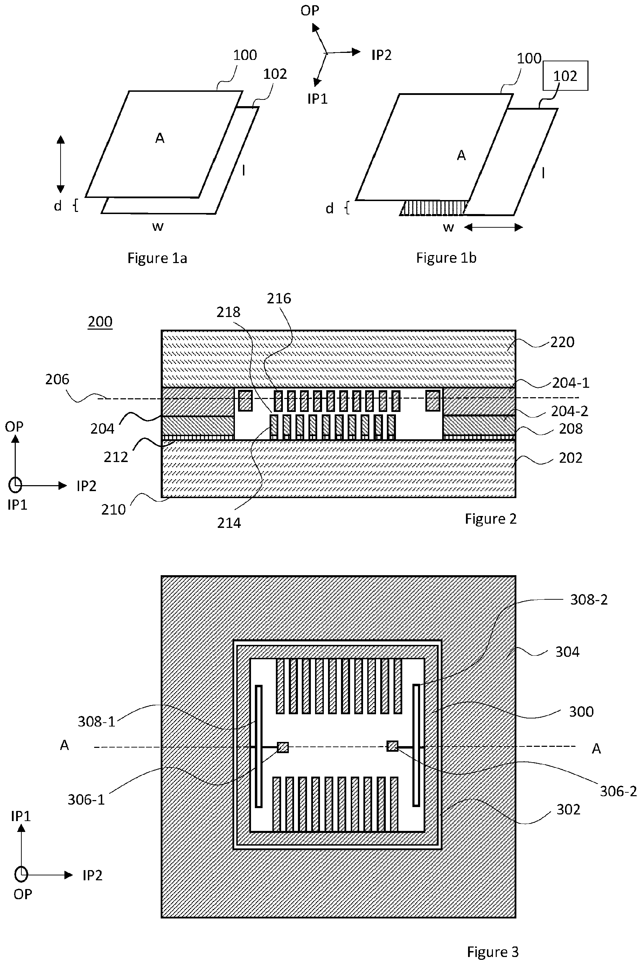

where $\varepsilon$ is permittivity of the dielectric isolation, A is overlapping area of the plates, d is distance between the plates, w is width plates and I is length of the overlapping parts of the of the plates, as illustrated in Figures 1a and 1b.

As an example of capacitive transduction, Figure 1a illustrates a sensing arrangement where capacitance of the parallel plate capacitor varies according to change in distance d between the plates. The shown capacitor includes a movable plate 100 and a static plate 102 that extend parallel to a plane along the two in-plane directions IP1 and IP2. The plates are separated by a distance d, and the movable plate 100 is able to move in the out-of-plane direction OP in response to a detected phenomenon so that the area A of overlap remains static, but the distance d-x varies with the change in displacement x. Capacitance change dC with respect to displacement x is thus

$$dC = \frac{\delta C}{\delta x} = -\frac{\varepsilon A}{(d-x)^2} \qquad (2)$$

Accordingly, the capacitance change of this type of capacitor is not constant but varies with distance between the plates. The response can be approximately linear over a small range of displacements of the movable plate, but with larger motions, it is nonlinear.

Figure 1b illustrates a sensing arrangement where capacitance of the parallel plate capacitor varies according to change in the area A of overlap between the plates. In this structure, the movable plate 100 can move in the in-plane direction IP2 in response to a detected phenomenon so that the distance d between the plates remains static, the length I of the area of overlap remains static, but the width w+x of the area of overlap varies accordingly with the change in displacement x. Already from equation (1) can be seen that the capacitance is directly proportional to the structural variable w. Capacitance change of the capacitor is

$$dC = \frac{\delta C}{\delta x} = \frac{\varepsilon l}{d} \qquad (4)$$

The response of this this type of capacitor is thus linear over a broad range of displacements and sensitivity of the capacitor depends on the length I and distance d between the plates.

Linear response and broader range of displacements would be preferred in many MEMS structures, but some practical aspects related to area modulated capacitances remain. The common way to maximise capacitive effect is to implement a MEMS structure by patterning into a device layer a plurality of electrically isolated comb structures wherein comb fingers of static and movable combs are interdigitated. For linear response, the comb fingers of the movable comb can be arranged to move parallel to the comb fingers and between comb fingers of the static comb. However, in order to avoid the risk that ends of comb fingers of the moveable comb hit and stick to the static comb, a lot of room needs to be left into the structures. This means that use of the available surface area in MEMS element designs is not efficiently optimised.

Document "Hewlett Packard's seismic grade MEMS accelerometer" of Homeijer, Lazaroff, Milligan, Alley, Wu, Szepesi, Bicknell, Zhang, Walmsley, and Hartwell from 2011 IEEE 24th International Conference on Micro Electro Mechanical System in 23-27 January 2011 describes plans for a sensor wherein an array of electrodes located on the proof mass moves relative to a stationary array of electrodes across a fixed gap between two separately processed wafers. The wafers are closed with a high temperature metal eutectic bond, and the electrode-to-electrode gap is set with oxide standoffs surrounding the metal interconnects. It is, however, easily understood that tolerances typical for wafer-level alignment are unlikely to enable adequately controlled overlap of minuscule structural features, like desired dimensions applied in comb fingers of MEMS structures, over the gap. Furthermore, even if the oxide standoffs would be fabricated with thin film processes, for many applications, they do not tend to provide adequate accuracy and consistency for dimensions of the electrode-to-electrode gap.

BRIEF DESCRIPTION

An object of the present disclosure is to describe a MEMS structure and a method for manufacturing the MEMS structure so as to address the above-described disadvantages.

This object is achieved by the MEMS structure and the method for manufacturing the MEMS structure which are defined by features of the independent claims. Some advantageous embodiments are disclosed in the dependent claims.

The disclosure is based on the idea of forming a static electrode and a movable electrode into a mechanical layer that includes a first and a second silicon layer. The gap between the static and movable electrodes for capacitive detection is arranged to the interface between the silicon layers, and their peripheries are closed by direct bonding to each other. The generated signal is arranged to vary according to overlap of the static and movable electrodes.

Due to the novel structure, the gap that separates static and movable electrodes is very accurately dimensioned, because it can be patterned into the interface between two directly bonded wafer layers. The accurate dimensioning enables accurate detection of overlap area of comb fingers over the gap, and use of area modulation enables linear signal response and large rotor motion.

BRIEF DESCRIPTION OF THE DRAWINGS

In the following the disclosure will be described in greater detail by means of exemplary embodiments with reference to the accompanying drawings, in which

Figure 1a illustrates a sensing arrangement where capacitance of the parallel plate capacitor varies according to change in distance d between the plates;

Figure 1b illustrates a sensing arrangement where capacitance of the parallel plate capacitor varies according to change in the area A of overlap between the plates;

Figure 2 illustrates basic semiconducting layers of an example MEMS structure;

Figure 3 illustrates a section of the MEMS structure described with Figure 2;

Figure 4 provides another side view section of the MEMS structure of Figure 2;

Figure 5 illustrates the principle of capacitive detection;

Figures 6a to 6c illustrate an exemplary configuration for capacitive detection;

Figures 7a and 7b illustrate another exemplary configuration for differential detection;

Figures 8a to 8h illustrate schematically an exemplary process for fabricating a MEMS structure.

DETAILED DESCRIPTION

The schematic drawing of Figure 2 illustrates basic semiconducting layers of an example MEMS structure. The MEMS structure 200 includes a substrate layer 202 and a mechanical layer 204. The mechanical layer is patterned to include electromechanical elements applicable for implementing a mechanical function of the MEMS structure. The mechanical layer typically includes a cavity in which the electromechanical elements can move. The cavity may be enclosed between the substrate layer 202 and a further capping layer 220, and peripheral regions of the mechanical layer 204. The term layer refers here to a mainly planar thickness of a material. The substrate layer and the mechanical layer are wafer layers that may be formed of a single wafer, or two or more wafers bonded to each other. Wafer layers in MEMS structures may be patterned to include local recesses and/or protrusions, but due to their original wafer disc form, wafer layers include planar forms that in the total MEMS structure align to identifiable layer planes, each of which can be considered to be parallel to a reference device plane 206.

As shown in Figure 2, the reference plane 206 extends into two mutually orthogonal in-plane directions IP1 and IP2. Figure 2 provides a side view to a section of the MEMS structure. The substrate layer 202 is described herein to be in the bottom of the MEMS structure so that a surface of each layer on the side of the substrate is called a bottom surface and a surface opposite it a top surface. Accordingly, in the example of Figure 2, the substrate layer 202 includes a bottom surface 210 facing outwards of the structure and a top surface 212 towards the next layer of the structure, and both surfaces are parallel to the reference plane 206. Surfaces of the layers may include local patterned sections, like cavities, recesses or protrusions, as shown with the mechanical layer 204 of Figure 2, but in each layer, it is possible to identify planar forms that align to a plane that is parallel to the reference device plane 206.

The substrate layer 202 and the mechanical layer 204 layer are electrically separated by an electrical insulator layer 208. Electrical separation means here that in parts where the substrate layer 202 and the mechanical layer 204 are in mechanical contact, the electrical insulator layer 208 is between them and electrically isolates one from another. The structure may include parts in which the mechanical layer has been etched off and there is thus no mechanical connection between the substrate layer 202 and the mechanical layer 204. In those parts, also the electrical insulator layer 208 may be removed from. In the example of Figure 2, parts of the top surface 212 of the substrate layer 202 are not covered by the mechanical layer 204 and material of the electrical insulator layer 208 has been removed from those parts.

In the disclosed examples, the mechanical layer includes a first silicon layer 204-1 and a second silicon layer 204-2. At least parts of the first silicon layer 204-1 and the second silicon layer 204-2 are directly bonded to each other. Direct bonding (also referred to as silicon direct bonding or silicon fusion bonding) refers here to a wafer bonding process wherein two silicon wafers are bonded to each other without an added intermediate layer or elements. For the direct bonding wafer surfaces may be pre-processed flat, clean and smooth so that when brought into contact, they stick together and form a weak bonding by physical forces. After this, adhesion based on intermolecular interactions including van der Waals forces, hydrogen bonds and strong covalent bonds may be increased by annealing. The type of created bonding is determined by the chemical species on the surfaces. In the case of silicon, hydrophilic and hydrophobic bonding is possible.

The mechanical layer 204 is patterned to include at least one static electrode and at least one movable electrode. The static electrode and the movable electrode are capacitively connected to generate a signal that varies according to movement of the movable electrode in relation to the static electrode parallel to the device plane. In most conventional structures, static electrodes and movable electrodes of area modulated capacitors have been implemented in form of a device layer comb structures wherein comb fingers of static electrodes and movable electrodes are interdigitated in a same wafer layer and move parallel to the reference device plane so that the areas of overlap of the comb fingers correspond to overlap of their projections in the out-of-plane direction OP. In order to improve linearity of the structure, static electrodes and movable electrodes of area modulated capacitors have in some alternative plans been formed into wafers interconnected through high temperature eutectic metal bonds controlled by oxide standoffs. For improved accuracy and larger rotor motion, in the novel structures disclosed herein, an out-of-plane gap between static and movable electrodes extends in the out-of-plane direction OP and the areas of overlap area between static and movable electrodes corresponds to overlap of their projections to the reference device plane 206. The improved linearity of the latter proposed solution is thus applied, but for further improvement, an out-of-plane gap 218 that separates the static and movable electrodes is formed into the mechanical layer 204, between electrode structures that have been patterned into the first silicon layer 204-1 and the second silicon layer 204-2.

The structure of Figure 2 shows a static electrode 214 and a movable electrode 216. The movable electrode 214 is in the first silicon layer 204-1 (the top part of the mechanical layer) and the static electrode 216 is in the second silicon layer 204-2 (the bottom part of the mechanical layer). The static electrode 214 and the movable electrode 216 are capacitively connected to generate a signal that varies according to movement of the movable electrode 216 in relation to the static electrode 214 parallel to the reference device plane. Provision of capacitive connection, for example, by electrically coupling the static electrode 214 to an external voltage source (not shown) is well known to a person skilled in the art. In the example of Figure 2, the signal varies according to movements of the movable electrode 216 in relation to the static electrode 214 in the second in-plane direction IP2. This variation corresponds to area of overlap of the movable electrode 216 and the static electrode 214 and can be determined from projections of the movable electrode 216 and the static electrode 214 into the reference device plane 206.

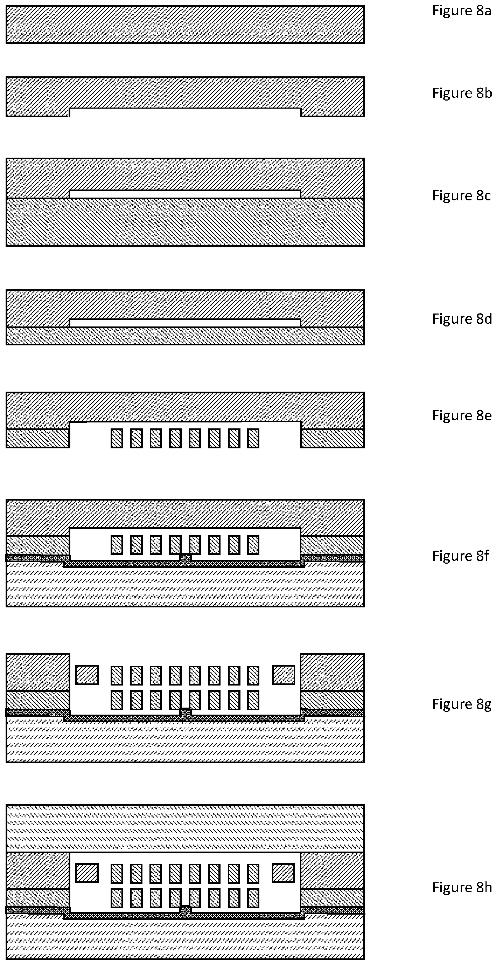

The out-of-plane gap 218 between the static electrode 214 and the movable electrode 216 is a void space formed between the first silicon layer 204-1 and the second silicon layer 204-2. As will be described in more detail with the manufacturing process later on, the out-of-plane gap is patterned inside the mechanical layer 204 before the first silicon layer 204-1 and the second silicon layer 204-2 are directly bonded to each other. To be movable, bottom surface of the movable electrode 216 may be above a plane that is parallel to a bonding interface between bonded parts of the first silicon layer 204-1 and the second silicon layer 204-2. Figure 2 illustrates an example wherein the structure includes a plurality of static and movable comb fingers and bottom surfaces of the movable electrodes align to a plane that is parallel to the reference device plane 206 and above the bonding interface between the first silicon layer 204-1 and the second silicon layer 204-2. Correspondingly, top surfaces of the movable electrodes align to a plane that is parallel to the reference device plane 206 and below the bonding interface between the first silicon layer 204-1 and the capping layer 220. Top surfaces of the static electrodes align to the bonding interface between the first silicon layer 204-1 and the second silicon layer 204-2. Bottom surfaces of the static electrodes are electrically insulated from the substrate layer by the electrical insulator layer 208. In the example of Figure 2, parts of the electrical insulator layer 208 are under each static electrode. As an alternative, the second silicon layer may be patterned to include one or more anchors that are supported on the substrate layer though the electrical insulator layer 208 and dimensioned to provide a common point of support to the static electrodes. In substrate layer forms of Figure 2, anchors may be released from the substrate layer by processing away thinner regions of the electrical insulator layer underneath the static electrodes. The substrate layer 202 may alternatively (cf. Figures 8a to 8h) include a cavity from which one or more anchors supporting the static electrodes protrude.

Figure 3 illustrates a section of the MEMS structure described with Figure 2, taken along the reference device plane 206 drawn to Figure 2. The section is in the first silicon layer 204-1 and shows exemplary movable electrodes formed into this layer. In the first silicon layer of the example of Figures 2 and 3, a bonding frame 304 surrounds a cavity 302 that encloses elements necessary to implement electromechanical functions of the MEMS structure. Inside the cavity 302 is a rotor frame 300, here a rectangular frame of four beams. The movable electrodes are comb fingers formed of cantilevers supported on one end to a beam of the rotor frame 300. In this example, the rotor frame 300 is supported on the substrate layer by means of anchor elements 306-1, 306-2 and spring structures 308-1, 308-2 that enable motion of the rotor frame, and thus motion of the movable electrodes along the second in-plane direction IP2. Alternatively, the rotor frame 300 can be suspended from the bonding frame 304 or from the capping layer 220.

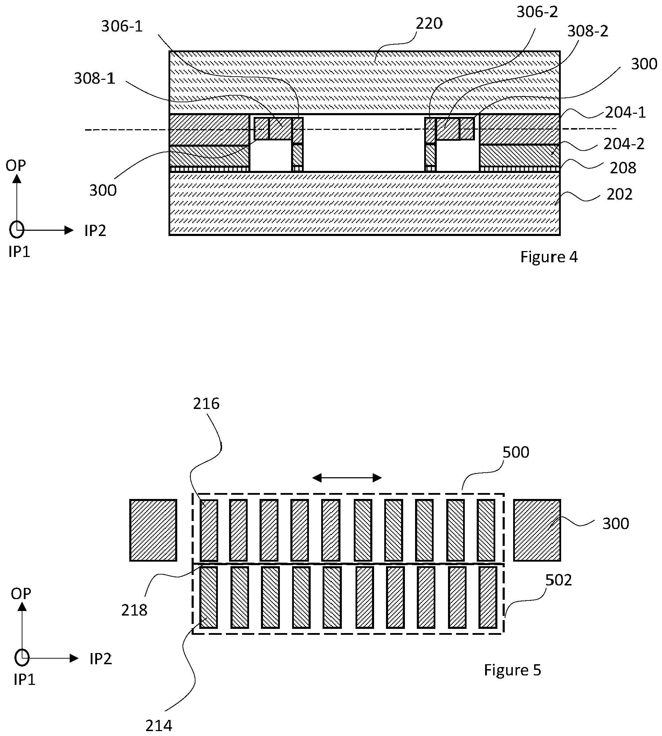

Figure 4 provides another side view section of the MEMS structure of Figure 2, taken along line A-A of the structure in Figure 3. The section shows the first silicon layer 204-1 and the second silicon layer 204-2. The second silicon layer 204-2 includes the static electrodes that are supported on the substrate layer 202, separated from it by the insulator layer 208.

The first silicon layer 204-1 includes the movable electrodes that extend parallel to the reference plane from the rotor frame 300. The rotor frame 300 is connected to two anchor elements 306-1, 306-2 via respective spring elements 308-1, 308-2 that enable back and forth movement of the rotor frame 300, and thus of the beams supporting the comb fingers in the second in-plane direction IP2. The anchor elements are patterned to extend in the out-of-plane direction OP from the substrate layer 202 through the insulator layer 208 and the second silicon layer 204-2 to the first silicon layer 204-1 so that it can be coupled to the in-plane extending spring elements 308-1, 308-2 (here in the second in-plane direction IP2). Peripheral regions in the interface between the first silicon layer 204-1 and the second silicon layer 204-2 are closed by direct bonding so that a closed cavity 310 is formed inside the mechanical layer between the substrate layer 202 and the cap layer 220.

As an example of capacitive transduction, Figure 5 illustrates the principle of capacitive detection with a simplified exemplary electrode comb combination. A first comb structure 500 includes one or more movable comb fingers 216 that extend in the first in-plane direction from the rotor frame 300. The rotor frame 300 is suspended from the substrate layer with a spring system that allows the rotor frame and thus the comb fingers of the first comb structure 500 to move in the second in-plane direction IP2 in response to acceleration. Top surfaces and bottom surfaces of the comb fingers align with a plane that is parallel to the reference device plane of the structure. A second comb structure 502 includes one or more static comb fingers 214 that in this example are supported or anchored on the substrate layer. In an initial state, when there is no induced acceleration, bottom surfaces of the movable comb fingers 216 and top surfaces of the static comb fingers 214 are parallel and separated by the out-of-plane gap 218. Projection of the movable comb finger 216 and projection of the static comb finger 218 on the reference device plane overlap to some extent. In this example configuration of Figure 5, the projections overlap in full and the capacitance between the first comb structure 500 and the second comb structure 502 reaches its largest value. Under external acceleration that has a component in the second in-plane direction IP2, the rotor frame 300 and the first comb structure 500 act as an inertial mass and become displaced in the IP2 direction while the second comb structure 502 remains in place. The area of overlap of the static and movable comb fingers on the reference device plane becomes smaller and capacitance between the first comb structure 500 and the second comb structure 502 decreases correspondingly. The change in capacitance corresponds to the detected acceleration in the second in-plane direction IP2. As discussed earlier, the first comb structure 500 and the second comb structure 502 form an area modulated capacitor, which provides a linear response over a range of displacements of the inertial mass. Capacitive actuation is based on this principle, only the other way round by using applied voltage to create a force that displaces the movable electrode.

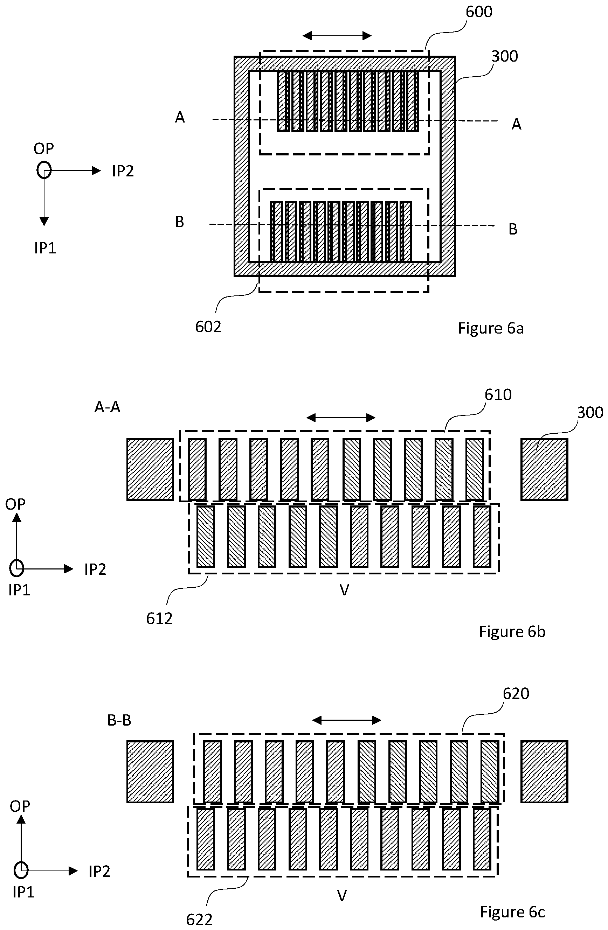

In view of Figure 5, Figures 6a to 6c illustrate an exemplary configuration for capacitive detection that corresponds to the structure of Figure 2 to 4. This exemplary structure is applicable to differential detection of acceleration. MEMS packages tend to bend or deflect which changes in ambient conditions, specifically with varying temperatures, which causes unwanted error to measurements. These measurement errors can be reduced by measuring one detected motion with two oppositely oriented structures and subtracting the measured signals. The subtraction eliminates a common error factor from the measurement, so a more accurate measurement result is achieved. Figure 6a illustrates an electrode configuration for the rotor frame 300 and two electrode comb sets 600, 602. The rotor frame is a rectangular frame of four beams, wherein one beam of the frame supports movable comb fingers of a first electrode comb set 600 and opposite beam of the frame supports movable comb fingers of a second electrode comb set 602. The drawing illustrates a top view so that movable comb fingers that extend from the rotor frame 300 show in the front and static comb fingers that are supported or anchored on the substrate layer as behind them. Figure 6b shows a side view of a first electrode comb set 600 taken along line A-A, and Figure 6c shows a side view of a second electrode comb set 602 taken along line B-B in Figure 6a.

As shown in Figure 6b, the first electrode comb set 600 includes movable comb fingers 610 and static comb fingers 612. The side view of Figure 6c shows the second electrode comb set 602 that includes movable comb fingers 620 and static comb fingers 622. The static comb fingers 612 of the first electrode comb set 600 and the static comb fingers 622 of the second electrode comb set 602 form separate measurable capacitances with the movable comb fingers 610 and with the movable comb fingers 620 and thus form two capacitors that are suitable for differential detection. The rotor frame 300, the movable comb fingers 610 of the first electrode comb set 600 and the movable comb fingers 620 of the second electrode comb set 602 are patterned to the first silicon layer and form a unified structure, a rotor, that can move back and forth in the second in-plane direction IP2. When the rotor moves in the positive IP2 direction, capacity of the first electrode comb set 600 increases and capacity of the second electrode comb set 602 decreases. When a signal corresponding to a capacity measured from the first electrode comb set 600 is deducted from a signal corresponding to a capacity measured from the second electrode comb set 602, effect of parasitic offset is eliminated or at least significantly reduced, and the resulting signal represents the detected acceleration.

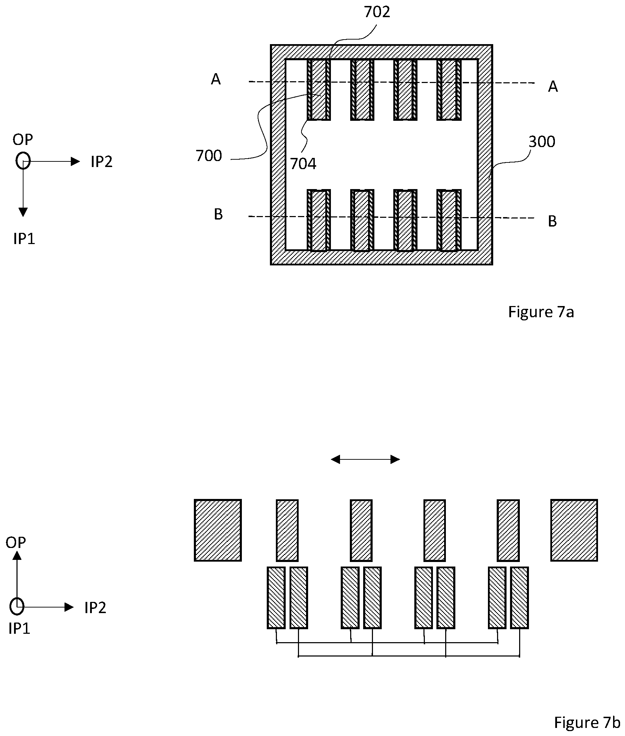

Figures 7a and 7b illustrate another exemplary configuration for differential detection. Figure 7a illustrates an electrode configuration for the rotor frame 300 and two electrode comb sets suitable for differential detection. The drawing illustrates a top view so that movable comb fingers that extend from the rotor frame 300 show in the front and static comb fingers that are supported or anchored on the substrate layer as behind them. Figure 7b shows a side view of electrode combs taken along line A-A. In this example, the electrode comb configuration is similar along lines A-A and B-B. A rotor includes the rotor frame 300 and movable comb fingers 700 that move with the rotor frame. The movable comb fingers 700 are capacitively connected to two sets of static comb fingers 702, 704. Each movable comb finger 700 is positioned opposite two static comb fingers so that when the rotor frame moves, the movable finger 700 is enabled to overlap both. The two static comb fingers 702, 704 are adjacent to each other in the first silicon layer but electrically separate so that two capacitors that respond in opposite phase to the motion of the rotor frame 300 are formed.

When the rotor moves in the positive second in-plane direction IP2, capacitance between a movable comb finger 700 and a static comb finger 702 of a first set of static comb fingers increases and capacitance between the movable comb finger 700 and a static comb finger 704 of a second set of static comb fingers decreases. Correspondingly, when the rotor moves in the negative second in-plane direction IP2, capacitance between a movable comb finger 700 and a static comb finger 702 of a first set of static comb fingers decreases and capacitance between the movable comb finger 700 and a static comb finger 704 of a second set of static comb fingers increases. When a signal corresponding to a capacity measured with movable comb fingers 700 and the first set of static comb fingers is deducted from a signal corresponding to a capacity measured with movable comb fingers and the second set of static comb fingers, the resulting signal represents the detected acceleration and effect of unwanted offset is eliminated or at least significantly reduced. As one movable comb finger can be applied in two capacitors, rotor size of Figures 6a to 6c can provide a stronger signal. Furthermore, the stators of the two capacitors are relatively close to each other, which means that external stress affects them quite similarly and can be even more effectively eliminated with differential detection. The structure is also very symmetric and thus less sensitive to external vibrations and can also provide more accurate measurements results.

In the disclosed structures, the gap that separates static and movable electrodes is very accurately dimensioned, because it has been patterned into the interface between two directly bonded wafer layers. This structure enables accurate detection of overlap area of comb fingers over the gap, which enables larger motion for the rotor and more linear signal response that conventional configurations.

Figures 8a to 8h illustrate schematically a process for fabricating structures described with Figures 2 to 7. The process relates to the structures of Figures 2 to 4, but the modifications for structures of Figures 6 and 7 are straightforward. The drawings illustrate only elementary features necessary to understand novel aspects of the process, for a person skilled in the art, various known grinding, masking and etching stages applicable to implement the process are well known and can be varied in many ways. Figures 8a to 8h illustrate fabrication of one MEMS structure, but the method is naturally applicable to fabrication processes in wafer level.

The method illustrated with Figures 8a to 8h is suitable for manufacturing a MEMS structure wherein a static electrode and a movable electrode are configured to generate a signal that varies according to movement of the movable electrode in relation to the static electrode parallel to a reference device plane. Figure 8a shows a first silicon wafer and the process begins by patterning into a first silicon wafer a recess (Figure 8b). The recess is formed to provide a gap, a void space that in the resulting MEMS structure extends in the out-of-plane direction between movable electrodes and static electrodes. As the gap can be patterned on a wafer surface with accurate microfabrication processes, its dimensions are very exact. It is clear that at this stage, some other functional elements and their parts may be patterned on the surface of the first silicon wafer, but these structures are not as such relevant for the disclosure and will not be shown or discussed in more detail herein. When the gap is formed, the first silicon wafer can be bonded to the second silicon wafer with a direct bonding process (Figure 8c).

When the mechanical layer with this internal gap is now formed, one or more static electrodes can be patterned from the bottom surface side to the second silicon wafer. For this, the second silicon wafer can be first thinned (Figure 8d) and the static electrode structure(s) then patterned (Figure 8e) to the thinned second silicon wafer. The side of the second silicon wafer can then be bonded (Figure 8f) to a handle wafer. The handle wafer may include a silicon substrate and an insulating layer to which the second silicon wafer is bonded (Figure 8f), for example by fusion bonding. In this simplified example, the handle wafer is shown as a planar silicon-on-insulator wafer (SOI), but the handle wafer can naturally include built-in sealed cavities for functions of the resulting MEMS structure (cavity-silicon-on-insulator, C-SOI). The process can then continue from the top surface of the mechanical layer, from the side of the first silicon wafer, by patterning (Figure 8g) to it one or more movable electrodes and spring structures that elastically suspend the movable electrode(s) from to the first silicon wafer or from the handle wafer. When the movable parts have been released and free to move, a cavity enclosing the movable and static electrodes and the gap between them can be closed by bonding (Figure 8h) a capping wafer to the first silicon wafer.

## Claims

1. A MEMS structure including a mechanical layer, which extends parallel to a reference device plane; wherein

   the mechanical layer is patterned to include a static electrode and a movable electrode enabled to move in relation to the static electrode parallel to the reference device plane;
   the static electrode and the movable electrode are connected to form a capacitor wherein capacitance of the capacitor varies according to an overlap of the static electrode and the movable electrode ;
   the mechanical layer includes a first silicon layer and a second silicon layer;
   parts of the first silicon layer and the second silicon layer are directly bonded to each other;
   the movable electrode is in the first silicon layer and the static electrode is in the second silicon layer;
   the movable electrode is separated from the static electrode by a first gap in the interface between the first silicon layer and the second silicon layer.

2. A MEMS structure according to claim 1, wherein the overlap of the static electrode and the movable electrode corresponds to projections of the static electrode and the movable electrode onto the reference device plane.

3. A MEMS structure according to any of the preceding claims, wherein the movable electrode and the static electrode include one or more comb fingers that extend parallel to the reference plane.

4. A MEMS structure according to any of the preceding claims, wherein

   the MEMS structure includes a substrate layer, electrically isolated from the mechanical layer by an insulating layer; and
   comb fingers of the movable electrode extend from one or more beams suspended from the substrate layer or the mechanical layer by one or more spring elements that enable back and forth movement of the beam parallel to the reference plane.

5. A MEMS structure according to claim 4, wherein the beams are part of a rectangular frame of four beams, wherein one beam of the frame supports movable comb fingers of a first electrode comb set and opposite beam of the frame supports movable comb fingers of a second electrode comb set.

6. A MEMS structure according to claim 5, wherein static comb fingers of the first electrode comb set and static comb fingers of the second electrode comb set are separately coupled to a voltage source and are separated from opposing movable comb fingers by the first gap to form two capacitors for differential detection.

7. A MEMS structure according to claim 6, wherein each movable movable comb finger is enabled to overlap two static comb fingers to form two capacitors that respond in opposite phase to motions of the frame.

8. A MEMS structure according to any of the preceding claims, wherein the MEMS structure includes a cap layer bonded to the second silicon layer and the movable electrode is separated from the cap layer by a second gap patterned into the interface between the second silicon layer and the cap layer.

9. A MEMS structure according to any of the preceding claims, wherein capacitance of the capacitor is used to detect acceleration parallel to the reference device plane.

10. A MEMS structure according to any of the preceding claims 1 to 8, wherein capacitance of the capacitor is used to actuate the movable electrode into motion parallel to the reference device plane

11. A method for manufacturing a MEMS structure wherein a static electrode and a movable electrode are configured to form a capacitor, capacitance of which varies according to movement of the movable electrode in relation to the static electrode parallel to a reference device plane, the method including:

    patterning recess to a first silicon wafer;
    direct bonding the first silicon wafer to a second silicon wafer;
    patterning static electrodes to the second silicon wafer;
    bonding the second silicon wafer to a handle wafer;
    patterning movable electrodes to the first silicon wafer;
    bonding a capping wafer to the first silicon wafer.

OP

IP2

IP1

100

102

A

l

d

w

Figure 1a

100

102

A

l

d

w

Figure 1b

200

218

216

220

204-1

206

204-2

204

208

212

202

OP

210

IP2

IP1

214

Figure 2

308-2

304

308-1

300

A — — — A

306-1

306-2

302

IP1

IP2

OP

Figure 3

Figure 4

Figure 5

Figure 6a

A-A

Figure 6b

B-B

Figure 6c

702

A ———— A

OP

IP2

700    704    300

B ———— B

IP1

Figure 7a

OP

IP2

IP1

Figure 7b

Figure 8a

Figure 8b

Figure 8c

Figure 8d

Figure 8e

Figure 8f

Figure 8g

Figure 8h

Europäisches
Patentamt

European
Patent Office

Office européen
des brevets

# EUROPEAN SEARCH REPORT

**Application Number**

**EP 23 15 9362**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/171836 A1 (STERKEN TOM [BE] ET AL) 5 July 2012 (2012-07-05) | 1-4,8-10 | INV.<br>G01P15/125<br>B81B3/00 |
| Y | * figures 2(a) - 2(g) * | 11 | |
| A | | 5-7 | |
| Y | US 2010/252898 A1 (TANAKA MASAYA [JP] ET AL) 7 October 2010 (2010-10-07) * figure 5 * | 11 | |
| X | EP 2 848 586 A1 (TEKNOLOGIAN TUTKIMUSKESKUS VTT OY [FI]) 18 March 2015 (2015-03-18) | 1,9,10 | |
| A | * figure 1 *<br>* paragraph [0026] - paragraph [0029] *<br>* paragraph [0055] - paragraph [0057] * | 8 | |

| TECHNICAL FIELDS SEARCHED (IPC) |
|---|
| B81C<br>B81B<br>G01P |

The present search report has been drawn up for all claims

| Place of search | Date of completion of the search | Examiner |
|---|---|---|
| Berlin | 3 August 2023 | Meister, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 9362

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2023

| Patent document cited in search report | | | Publication date | Patent family member(s) | | | Publication date |
|---|---|---|---|---|---|---|---|
| US 2012171836 | A1 | | 05-07-2012 | EP | 2452349 | A1 | 16-05-2012 |
| | | | | JP | 2012532470 | A | 13-12-2012 |
| | | | | US | 2012171836 | A1 | 05-07-2012 |
| | | | | WO | 2011003803 | A1 | 13-01-2011 |
| US 2010252898 | A1 | | 07-10-2010 | JP | 4793496 | B2 | 12-10-2011 |
| | | | | JP | 2010260167 | A | 18-11-2010 |
| | | | | US | 2010252898 | A1 | 07-10-2010 |
| EP 2848586 | A1 | | 18-03-2015 | EP | 2848586 | A1 | 18-03-2015 |
| | | | | WO | 2015036657 | A1 | 19-03-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HOMEIJER ; LAZAROFF ; MILLIGAN ; ALLEY ; WU ; SZEPESI ; BICKNELL ; ZHANG ; WALMSLEY ; HARTWELL.** Hewlett Packard's seismic grade MEMS accelerometer. *2011 IEEE 24th International Conference on Micro Electro Mechanical System,* 23 January 2011